# EUROPEAN PATENT SPECIFICATION

(11) **EP 1 627 351 B1**
(45) Date of publication and mention of the grant of the patent: **28.05.2008**
(21) Application number: 04732148.4
(22) Date of filing: 11.05.2004
(51) Int. Cl.: G06Q 10/00

(54) **METHOD OF MANUFACTURING RECYCLABLE ELECTRONIC PRODUCTS AND ELECTRONIC PRODUCTS OBTAINED BY THE METHOD**
VERFAHREN ZUM ERZEUGEN WIEDERVERWERTBARER ELEKTRONISCHER PRODUKTE UND MITTELS DES VERFAHRENS GEWONNENE ELEKTRONISCHE PRODUKTE
PROCEDE DE FABRICATION DE PRODUITS ELECTRONIQUES RECYCLABLES ET PRODUITS ELECTRONIQUES AINSI OBTENUS

(30) Priority: 16.05.2003 GB 0311251
(43) Date of publication of application: 22.02.2006
(73) Proprietor: Koninklijke Philips Electronics N.V., 5621 BA Eindhoven (NL)
(72) Inventor: GOLDING, Benjamin T, c/o Philips IP & Standards, Redhill Surrey RH1 5HA (GB); BIRD, Neil C., c/o Philips IP & Standards, Redhill Surrey RH1 5HA (GB); GUTHRIE, Brian J., c/o Philips IP & Standards, Redhill Surrey RH1 5HA (GB)
(74) Representative: Damen, Daniel Martijn
(86) International application number: PCT/IB2004/001572
(87) International publication number: WO 2004/102442

(56) References cited:
- EP-A- 0 916 457
- EP-A- 1 205 405
- DUGERN O V ET AL: "EINE MODULARE GRUNDSTEUERUNG FUR FLEXIBLE MONTAGEZELLEN" AUTOMATISIERUNGSTECHNISCHE PRAXIS - ATP, OLDENBOURG VERLAG. MUNCHEN, DE, vol. 32, no. 1, 1990, pages 22-29, XP000126014 ISSN: 0178-2320

## Description

### Background of the Invention

The present invention relates to a method of manufacturing an electronic product comprising modules and radio units, and further relates to modules descriptions and product blueprints suitable for practising said methods. The present invention has particular, but not exclusive, application to producing and recycling electronic products such as desktop calculators, alarm clocks, personal music players, radios and other such common electronic products.

The number of electronic products in use throughout the world is growing dramatically, whilst product life cycles are reducing. At the end of a life cycle, recycling parts from a product is crude and difficult since most parts are wired or interconnected together permanently on a printed circuit board (PCB). Material recovery is limited. This has led to a dramatic increase in the use of landfill sites for electronic waste that legislators in many jurisdictions including Europe have realised is unsustainable. In Europe, the Waste Electrical and Electronic Equipment Directive (the "WEEE directive") was recently passed as European law and stipulates that end-of-lifecycle equipment is collected for recovery, recycling and re-use.

Current products such as calculators or personal stereos or mobile telephones share many common features such as display modules and keypads. Recycling or recovering such useful modules in current products is at present difficult due to the existence of physical interconnects.

United States patent US 5,832,371 describes a modular cellular telephone having separate electromechanical and electronic modules which are detachably electrically interconnected. Whilst the invention enables a certain degree of recycling of the telephone to be achieved, any reuse of the modules is limited to a telephone product.

### Summary of the Invention

It is therefore an object of the present invention to provide a method of manufacturing an electronic product in which modules may be reused in different products.

According to a first aspect of the present invention there is provided a method for manufacturing an electronic product from a plurality of reusable electronic modules operable to transmit and receive wireless messages according to a predefined protocol, each module including description data which describes its capabilities, and wherein at least one module is a primary module operable to establish and co-ordinate a product intranet, the method comprising:
providing a product intranet blueprint describing modules required for the product,
selecting modules for the product including a primary module based on a modules respective description data and the product blueprint, and establishing a product intranet comprising said selected modules and by which intranet said product at least in part operates.

According to a second aspect of the present invention there is provided an electronic product comprising:
a housing having a plurality of electronic modules each having transceiver means for transmitting and receiving messages, and wherein at least one of the modules is a primary module having;
means for storing a product intranet blueprint; and
means for establishing a product intranet according to the blueprint.

Owing to the invention electronic modules such as keypads and display modules are provided with a radio unit which is capable of transmitting and receiving radio messages according to a predefined protocol. A primary module comprising a radio unit and a processor establishes and coordinates an intranet between the modules. Hence, data generated by a module (such as a key press) is transmitted via the wireless intranet to the primary module for processing according to product application code. Hence, short range radio links within the product replace at least in part some of the interconnect wiring required traditionally. Furthermore, the modules comprise description data which, when matched with product blueprint data in a factory enable the factory to select appropriate modules and assemble a product.

In a preferred embodiment the product operates by exchanging messages comprising radio data packets according to a communication protocol as defined by the ZigBee Alliance. The primary module is supplied with product program code which defines the function of the product, for the purposes of this embodiment, as a desktop calculator. A product blueprint describes the modules required for the product in a manner consistent with a data description stored by the module, the description describing the capabilities of the module such as class, type and other attributes. For this calculator embodiment, a keypad module and a display module are therefore required. The factory selects appropriate modules and places them in a calculator housing designed to house the modules.

Once assembled in the housing, the primary module establishes an intranet with the other modules by registering the modules with itself and supplying a periodic reference or beacon signal. Hence input on the keypad is transferred as data in a radio message to the primary module, which receives the data and processes said data according to the program code. For example, the data is transmitted to the display module and displayed on the display. Further input is operated on in accordance with the program code so that the product functions as a calculator.

Advantageously, the description data of a module may be received wirelessly from the module, enabling automated factory recycling of the module to another product requiring such a module.
Other aspects according to the invention include electronic modules for use in electronic products, and a product intranet blueprint for uploading to a recyclable electronic product, comprising data describing module requirements for said product.

Further features and advantages of the present invention are recited in the attached claims, the disclosure of which is incorporated herein by reference, and to which the reader is now directed.

### Brief Description of the Drawings

The present invention will now be described, by way of example only, and with reference to the accompanying drawings wherein:
Figure 1 is an exploded three-dimensional view of a desktop calculator embodying the present invention;
Figure 2 illustrates electronic modules including radio units of the calculator product;
Figure 3 illustrates a radio unit, protocol stack and radio message;
Figure 4 gives example description data stored by modules;
Figure 5 shows an example electronic blueprint for manufacturing a product;
Figure 6 illustrates schematically a factory set-up for manufacturing a product;
Figure 7 illustrates example steps in the form of a flowchart for a manufacturing process;
Figure 8 illustrates a product having a product intranet with a broadcast range;
Figure 9 illustrates an electronic product in the form of a digital clock comprising modules recycled from a previous product.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### Detailed description of the Invention

In the following example assembly of a recyclable electronic product in the form of a desktop calculator is described, the product comprising an intra-product communication network operating according to a radio protocol such as that defined as the ZigBee standard by the ZigBee Alliance. Disassembly of the modules and reuse in an alarm clock is further described. These examples are exemplary, and those skilled in the art will recognise many products having the same, similar or additional modules may be assembled and reused.

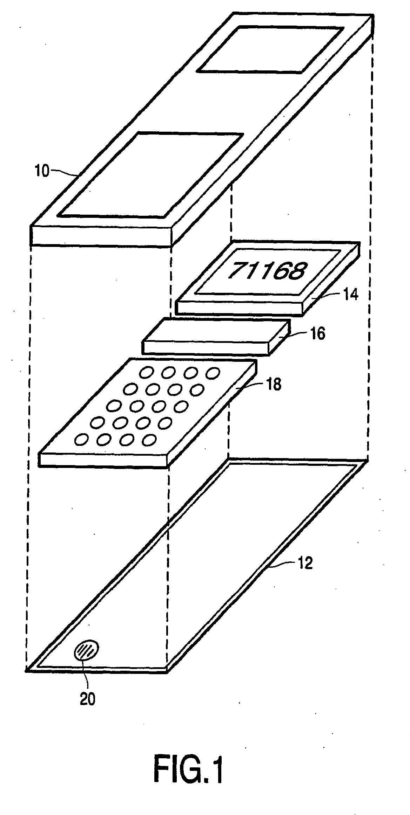

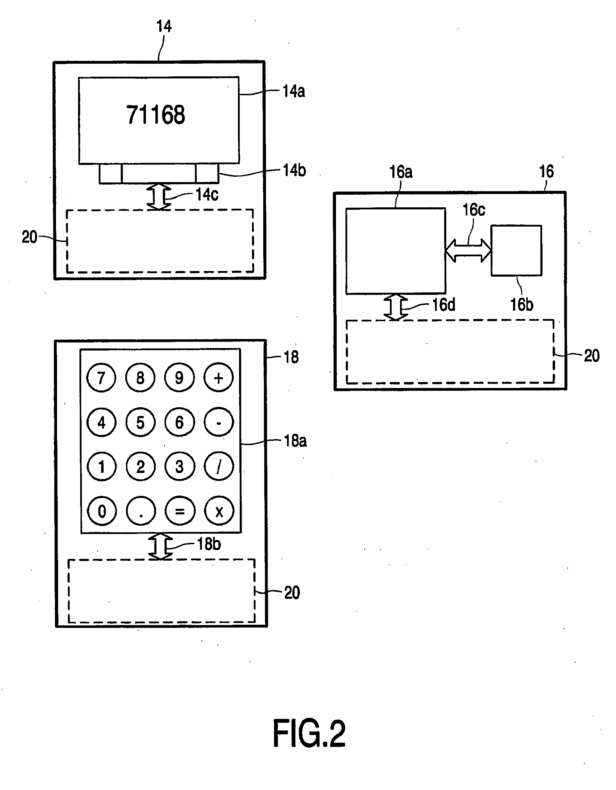

Figure 1 shows an electronic product in the form of a desktop calculator. The housing 10,12 encloses reusable electronic modules 14, 16 and 18. The modules are powered by battery power supply 20. In this embodiment of a calculator, the module 14 is a display module, module 16 a processing module and module 18 a keypad module. The modules are described in more detail in Figure 2.

Figure 2 illustrates modules 14, 16 and 18. Display module 14 has a radio unit 20 connected by data bus 14c to a display part 14a. In this example the display part comprises a seven segment liquid crystal display able to display one row of ten characters as is typically found in a desktop calculator. Keypad module 18 comprises a 4x4 push button keypad connected by bus 18b to a radio unit 20. The data bus may be a simple three wire configuration comprising input/output lines and a control line as well known to those skilled in the art.

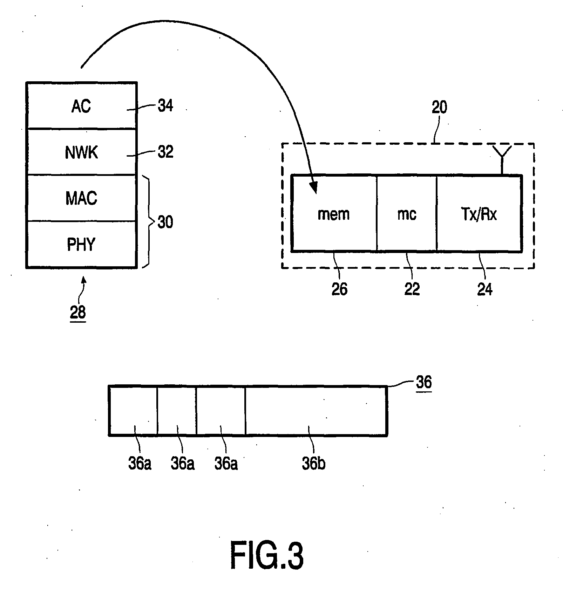

Processor module 16 comprises processing means in the form of an 8-bit microcontroller such as the well known 8051 integrated circuit microcontroller. The module preferably comprises storage memory 16b interconnected to the microcontroller by bus 16c. The memory 16b may comprise a non-volatile memory, for example FLASH memory for storing product application program code. The code in this embodiment comprises program instructions for a desktop calculator application. More complex microcontrollers or microprocessors and memory arrangements may of course be provided in a processing module depending on an intended application class as will be described shortly. The microcontroller 16a is also linked by data bus 16d to a radio unit 20. An example radio unit 20 is shown in Figure 3.

Figure 3 illustrates a radio unit 20, comprising a radio microcontroller 22 (such as the low cost 8051) 22, memory 26 and a transceiver 24 with antenna 25. The memory 26 stores program code describing the ZigBee^{™} digital radio protocol. Those skilled in the art often use the OSI layer or "stack" model to describe such a protocol or standard. The ZigBee radio "stack" 28 is shown in the Figure and comprises lower hardware layers 30 (the physical layer 'PHY' and medium access control 'MAC' layer), a software network 'NWK' or link layer 32 and application code 'AC' layer 34.

The radio unit stores the "stack" 28 in radio memory 26 (which may itself be integral to microcontroller 22) and transmits and receives formatted datagrams or radio messages 36 comprising header fields 36a and data or payload field 36b. Conceptually, in operation, data to be transmitted is generated by the application layer code 34 and inserted in the payload section of a message 36. The message is then operated on by the network layer (for example by inserting source and destination addresses for the intended destination in header fields 36b) which in turn passes the message through the MAC and PHY layers before finally the message is transmitted over the air via transceiver 24 and antenna 25. Such a mode of operation wherein a protocol "stack" is provided in a radio unit which then operates according to the stack is well known to those skilled in the art of radio systems, and enables interoperability between radio units having the same protocol.

The ZigBee protocol is currently being standardised as IEEE802.15.4 and in general defines a low power, low bandwidth radio standard operating primarily in the ISM band at 2.4GHz. It is primarily targeted at control and instrumentation applications such as lighting and heating. A ZigBee radio unit has an estimated operating range up to about 50m or so and each radio device or unit comprises a unique identifier 64 bits long to enable addressing of messages and registration on a network.

Further details of the ZigBee radio system are available on the ZigBee Alliance website (www.zigbee.com) and also disclosed in applicants copending application WO 01/37488 published 25^{th} of May 2001 and to which the interested reader is now directed.

Returning to Figure 2, unit 20 in display module 14 has display application code which transfers data received in messages 36 to display controller 14b via interconnection 14c with the display controller subsequently displaying said data on display 14a. Similarly, keypad module 18 is provided with application code which causes the radio unit 20 to monitor the keypad 18a, detect a key press and transfer a code (e.g. ASCII) representing the key to unit 20. The unit may then generate a radio message 36 containing the code for transmission.

Primary processing module 16 comprises overall application program code, the application here being that of a calculator. Additionally, the radio unit 20 of module 16 monitors for messages comprising key press data and may either transmit the data to display module 14 for display, or act on the data (e.g. performing a summation) and then transmit the result to display module 14 for display. Hence, the overall operation of the calculator is coordinated by primary processing module 16.

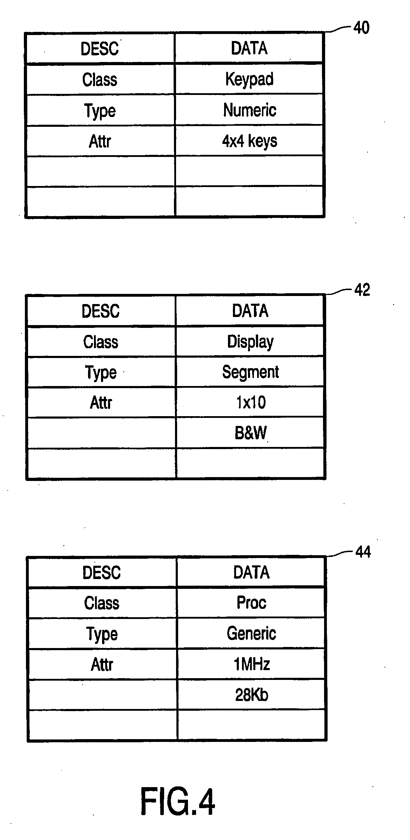

Such a product in which modules transfer information via radio links requires the modules to form a short range radio network within the product at manufacture. To enable reuse or recycling of the modules, a classification scheme is also required so that modules, when forming a network, or when being selected for a product in a manufacturing factory or production line, can be identified and their capabilities assessed. An example scheme showing description data 40, 42, 44 stored by the modules 18, 14, and 16 respectively is shown in Figure 4. The description and capabilities of the modules are classified under general heading Class, Type and Attribute.

Table 40 shows description data for keypad module 18, which is stored in memory 26 of radio unit 20. As shown in the Figure, the module has a class 'Keypad', a type 'numeric' and attributes ('Attr') of 4x4 keys. Hence, a different module having a different keypad (such as one suitable for a mobile phone) with for example 20 keys may have associated description data of Class=Keypad, Type='alphanumeric' and Attr='4x5 keys.'

Similarly, table 42 shows example description data associated with and stored in the radio unit of display module 14. In this example the module 14 has class='Display', type='segment' and Attr='1x10' indicating one row of ten characters as the capability of the display. Of course, other display types such as matrix displays may have type='matrix' and different Attributes indicating for example a pixel resolution and colour (for example, 120x120xRGB).

Table 44 stored in radio unit of primary processing module 16 describes the modules as Class = 'proc' (for processing), Type = generic and Attr = 1 MHz, 32kb. Hence the processor or microcontroller is programmable and has clock frequency and onboard cache memory as indicated in the Attr fields of description data table 44.

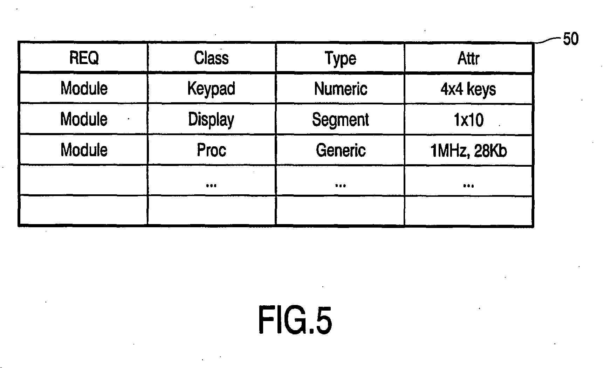

The provision of module description data 40, 42, 44 advantageously enables the product to be automatically manufactured or the modules from one product to be recycled to another product according to a product intranet blueprint. Such a blueprint is shown in Figure 5 as table 50. The blueprint 50 describes a module (by way of class, type and attribute) required (REQ) for the product. These modules, when incorporated in a product will exchange data via their radio units 20 in a product intranet radio network as previously described. In this example of a calculator, the blueprint 50 requires a keypad, display and processor (PROC) module as shown by way of example in Figure 5.

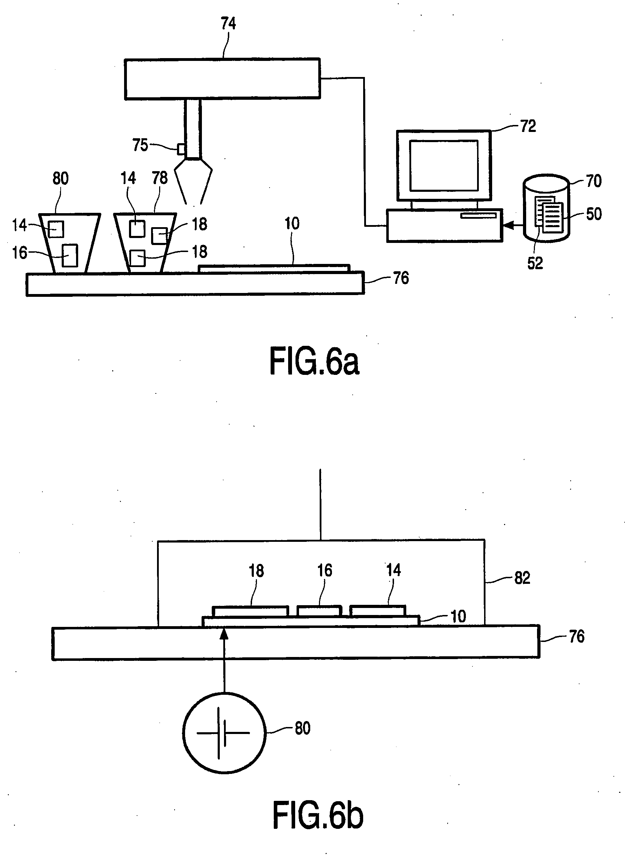

Figure 6a shows an example schematic manufacturing line for the product. In the Figure, factory computer 72 controls a "pick and place" machine 74. Incorporated in the machine is radio unit 75 which is capable of operating the ZigBee standard as described earlier. Numerous modules 14,16,18 are provided in powered racks 78, 80 on the production line 76, which also has a product housing 10. The computer 72 has access to store 70 which stores product intranet blueprint 50 and optionally product application code 52. Under control of computer 72, pick and place machine 74 contacts a module 18 via radio 74 and requests a data description 40. The module radio unit 20 replies with its stored data description 40 which is transferred to computer 72. The computer compares the description 40 with the blueprint requirements and if there is a match the pick and place machine 74 retrieves the module 18 and places it in the housing 10. This is repeated until all modules according to the blueprint have been selected and placed in the housing 10. Additionally, the factory computer uploads the program application code and product blueprint to the processor/microcontroller if it is a programmable processor. The housing is then transported to a product intranet establishing area of the factory as shown in Figure 6b.

In Figure 6b, the product comprising housing 10 and selected modules 14,16,18 are provided with power 80 from production line 76. Additionally, electromagnetic interference (EMI) shielding 82 in the form of a faraday cage has been placed over and around the product. The shielding isolates the product to prevent nearby modules of other products from joining the product intranet. Under control of the primary processing module 16, the intranet is then established as follows.

Application code in the primary module 16 causes its radio unit 20 to begin broadcasting a periodic reference signal containing a randomly chosen 16-bit network identifier. The module 14 receives the periodic (or "beacon") signal and initially respond with their unique 64-bit identifiers and description data in a request to join the network. The primary module receives these identifiers (and not the requests of other modules in the factory due to EMI shielding 82), and compares the description data with the blueprint data. If the module is a required module, the primary module 16 then allocates a shorter 8-bit radio identity code (RIC) which it transmits to the requesting module 14, and stores the identifier and short radio code (8-bit identifier) in an intranet table in memory 26. The module receives the RIC, stores it and acknowledges the message by sending an acknowledge message (ACK). This is repeated for other modules 18. Hence, the modules are registered with the primary module thereby establishing the product intranet. Following registration, modules 14,18 listen for beacons having their network identifier and send messages containing their respective radio identity codes to the primary module for processing.

Once the network or intranet is established, EMI shielding 82 is removed and the product moved on in the production line for final finishing (for example completing housing 10 with housing 12) and testing.

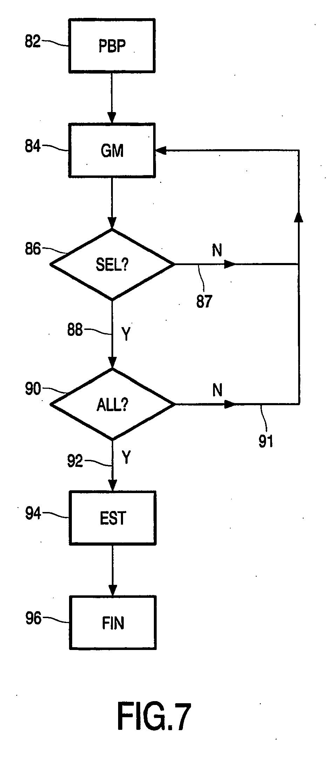

Figure 7 illustrates the general process described above in relation to Figure 6a, b. The process starts at step 82 in which factory computer retrieves a product blueprint (PBP). Flow continues to step 84 wherein a module is contacted (CM) and provides its description data to the computer which then at step 86 compares the data with the blueprint to decide whether to select (SEL?) the module for incorporation in the product currently being manufactured. If the module is not selected process flow continues via path 87 back to step 84 where another module is contacted.

However, if the description data matches the blueprint requirements the module is selected (path 88) and process continues to decision step 90 where the factory computer tests whether it has selected all required modules for the product (ALL?). If the description data does not match the blueprint requirement the process steps 84, 86 are repeated as indicated by path 91. Once all modules have been selected, flow continues from step 90 via path 92 to step 94 wherein the blueprint data is uploaded to the primary module and wherein the modules subsequently establish (EST) a product intranet as previously described. Finally, the process finishes (FIN) at step 96 wherein the product is tested and made ready for the consumer.

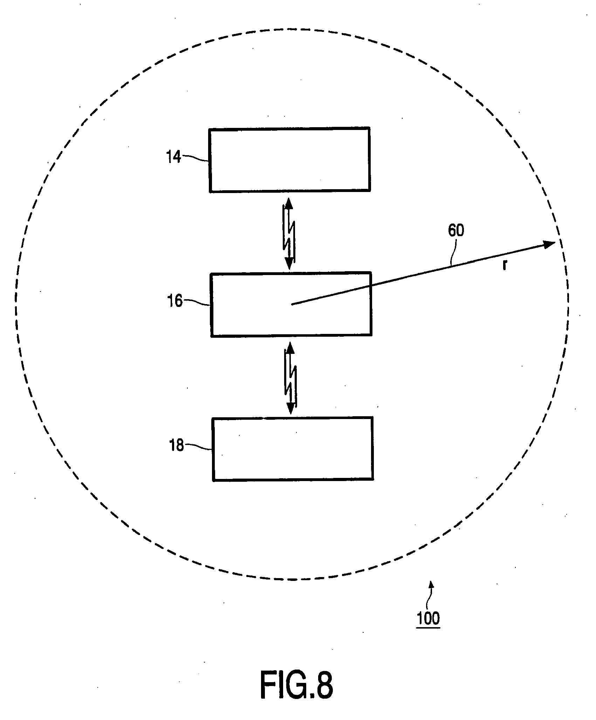

Figure 8 illustrates the product intranet 100 having a radio range 60 denoted 'r' in the diagram. The radio range of a typical ZigBee radio 20 is about 10-50m. This range is specified in part by the requirements of the ZigBee standard which specifies a receiver sensitivity (thereby defining the weakest input signal that the transceiver must be able to receive) of about - 85dBm or better with a transmit power of OdBm (~1-10mW). Of course, altering the transmit power also alters range, and a better receiver sensitivity allows a lower transmit power. Applicants current ZigBee radio units have a sensitivity of around -100dBm and allowing for indoor path loss of 40dBm, calculations indicate a minimum transmit power of around 300 microwatts is capable. This constrains the broadcast range of a radio unit to about metre or less.

Hence, control means in the form of a programmable attenuator circuit may be used to reduce the transmit power of the transmission circuitry of the transceiver. In the manufacturing process, the radio units of the modules may broadcast over the normal ZigBee range until the product intranet is established, after which the range is attenuated. The attenuator circuit may be operated via application code instructions included in the radio unit, thereby enabling software control of the range.

Additionally, or alternatively, the range 60 may be attenuated using shielding within the product housing 10 and 12 so that the range of the intranet is restrained substantially within the housing. For example, an aerosol solution of Nickel screening compound (NSC - nickel powder in a thermoplastic resin) may be sprayed on the internal surfaces of the housing 10, 12. The company ElectrolubeTM manufacture and sell such a product having a product code NSC400H. Other example shielding solutions well known to those skilled in the art comprise silicone sponge foam and knitted wire mesh tape.

A combination of housing shielding and transceiver/software design enable the range to be substantially reduced whilst saving power. Hence, although ZigBee radio units are designed with very low duty cycles (for example the transmitters are only active just before a beacon signal leading to for example an average "on" time of only a few seconds in an hour) the battery life may be advantageously extended using the above described techniques.

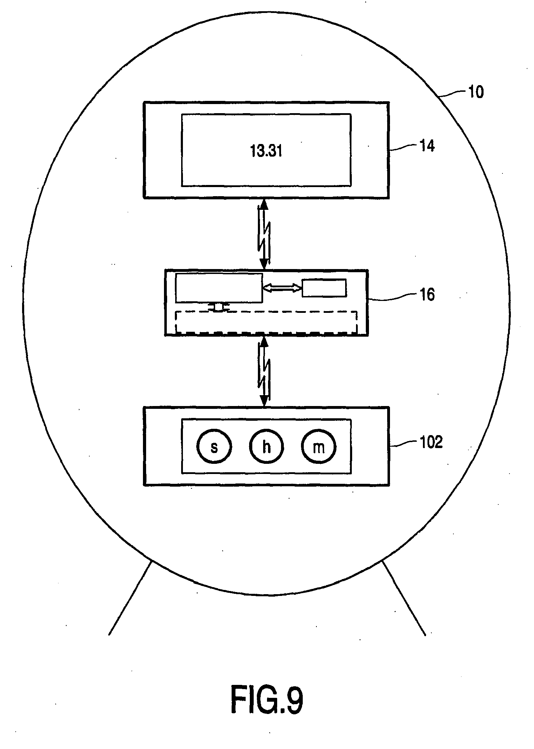

As will be recognised by those skilled in the art, the product, modules and manufacturing process hereinbefore described readily enable efficient recycling of said products and their component modules. For example, a blueprint 50 for a product in the form of a digital clock may require a display module, a processing module and a three button module for setting the time (set, hour, min). The production line of Figure 6a may disassemble a calculator product at end of life, and assemble the new product (clock) comprising a new housing 10, the display module 14 and reprogrammed primary module 16, and a three button keypad module 102 as shown in Figure 9.

In the above a method for manufacturing an electronic product comprising modules 14, 16, 18 having a radio communication protocol and communication means 20 is described. The modules comprise description data 40 which, when matched with product blueprint data 50 enable factory selection of the modules for a product. The interconnections between the modules within the product are partially replaced by a radio intranet 100 established by a primary module 16 of the product. The range of the intranet 60 may be constrained substantially within the housing 10, 12 of the product. The modules which may for example be separate display and keypad modules can, at the end of life of the product, be selected for reuse in other products according to respective product blueprint data 50 and their description data 40.

Furthermore, this enables efficient assembly, disassembly of the product and reuse of at least some of the modules in other products according to product blueprint data.

From reading the present disclosure, other modifications will be apparent to persons skilled in the art. For example, products other than those described above may be designed with the invention in mind, and other radio equipped modules having desired functions may be created, provided that description data and blueprint data follow the same classification scheme.

Other modifications may involve other features which are already known in the design, manufacture and use of radio units, electronic modules and factory production lines and component parts thereof and which may be used instead of or in addition to features already described herein.

## Claims

1. A method for manufacturing an electronic product from a plurality of reusable electronic modules (14,16) operable to transmit and receive wireless messages (36) according to a predefined protocol, each module including description data (40) which describes its capabilities, and wherein at least one module is a primary module (16) operable to establish and co-ordinate a product intranet, the method comprising:
providing a product intranet blueprint (50) describing modules required for the product,
selecting modules for the product including a primary module based on a modules respective description data and the product blueprint, and
establishing a product intranet (100) comprising said selected modules and by which intranet said product at least in part operates.

2. A method according to claim 1, wherein said product blueprint (50) further includes product program code (52) for said primary module, and wherein said blueprint is uploaded to the primary module prior to establishing said product intranet.

3. A method according to claim 1 or 2, wherein the modules include unique identifiers and wherein the establishing of said product intranet comprises the primary module wirelessly exchanging a network identifier with the identifiers of the other selected modules to register said modules.

4. A method according to claim 1,2 or claim 3, wherein the selected modules are arranged within a shielded (82) area prior to establishing said intranet to ensure only selected modules are included in said intranet (100).

5. A method according to claim 4, wherein the modules are arranged substantially within a product housing (10,12) following said selecting.

6. A method according to claim 5, wherein the transmit power of the modules is decreased to restrict the range (60) of the product intranet.

7. A method according to claim 6, wherein the range of the intranet is between one centimetre and one metre.

8. A method according to claim 5, wherein said product housing (10,12) comprises shielding which restricts the range of the intranet to substantially within said housing.

9. An electronic product comprising:
a housing (10) having a plurality of electronic modules (14,16) each having transceiver means (24) for transmitting and receiving messages (36), and wherein at least one of the modules is a primary module (16) having;
means (16b) for storing a product intranet blueprint; and
means (22,28) for establishing a product intranet according to the blueprint.

10. An electronic product according to claim 9, further comprising control means (22) for controlling the power output by said transceiver means.

11. An electronic product according to claim 10, wherein said control means further comprise a programmable attenuator.

12. An electronic product manufactured in accordance with any of the methods as claimed in claims 1 to 8.

## Patentansprüche

1. Verfahren zum Herstellen eines elektronischen Produkts aus einer Vielzahl von wieder verwendbaren elektronischen Modulen (14, 16), die so funktionieren, dass sie drahtlose Nachrichten (36) gemäß einem vorher festgelegten Protokoll senden und empfangen, wobei jedes Modul Beschreibungsdaten (40) enthält, die seine Fähigkeiten beschreiben, und wobei mindestens ein Modul ein Primärmodul (16) ist, das so funktioniert, dass es ein produktinternes Netz erstellt und koordiniert, wobei das Verfahren Folgendes umfasst:
- Schaffen eines Entwurfs (engl. blueprint) (50) für ein produktinternes Netz, der für das Produkt erforderliche Module beschreibt;
- Auswählen von Modulen für das Produkt einschließlich eines Primärmoduls basierend auf Module betreffenden Beschreibungsdaten und dem Produktentwurf und
- Erstellen eines produktinternen Netzes (100) mit den genannten ausgewählten Modulen, wobei das genannte Produkt zumindest teilweise durch das interne Netz funktioniert.

2. Verfahren nach Anspruch 1, wobei der genannte Produktentwurf (50) ferner einen Produktprogrammcode (52) für das genannte Primärmodul enthält und wobei der genannte Entwurf vor dem Erstellen des genannten produktinternen Netzes in das Primärmodul hinaufgeladen wird.

3. Verfahren nach Anspruch 1 oder 2, wobei die Module eindeutige Identifikatoren enthalten und wobei das Erstellen des genannten produktinternen Netzes umfasst, dass das Primärmodul drahtlos einen Netzidentifikator mit den Identifikatoren der anderen ausgewählten Module austauschen kann, um die genannten Module zu registrieren.

4. Verfahren nach Anspruch 1, 2 oder 3, wobei die ausgewählten Module vor dem Erstellen des genannten internen Netzes in einem abgeschirmten (82) Bereich angeordnet werden um sicherzustellen, dass lediglich ausgewählte Module in dem genannten internen Netz (100) eingeschlossen werden.

5. Verfahren nach Anspruch 4, wobei die Module nach dem genannten Auswählen im Wesentlichen im Inneren eines Produktgehäuses (10, 12) angeordnet werden.

6. Verfahren nach Anspruch 5, wobei die Sendeleistung der Module verringert wird, um die Reichweite (60) des produktinternen Netzes einzuschränken.

7. Verfahren nach Anspruch 6, wobei die Reichweite des internen Netzes zwischen einem Zentimeter und einem Meter liegt.

8. Verfahren nach Anspruch 5, wobei das genannte Produktgehäuse (10, 12) eine Abschirmung umfasst, die die Reichweite des internen Netzes auf im Wesentlichen im Inneren des genannten Gehäuses einschränkt.

9. Elektronisches Produkt, das Folgendes umfasst:
- ein Gehäuse (10) mit einer Vielzahl von elektronischen Modulen (14, 16), die jeweils Transceivermittel (24) zum Senden und Empfangen von Nachrichten (36) aufweisen, und wobei mindestens eines der Module ein Primärmodul (16) ist mit
- Mitteln (16b) zum Speichern eines Entwurfs des produktinternen Netzes und
- Mitteln (22, 28) zum Erstellen eines produktinternen Netzes gemäß dem Entwurf.

10. Elektronisches Produkt nach Anspruch 9, das ferner Steuermittel (22) zum Steuern der von den genannten Transceivermitteln ausgegebenen Leistung umfasst.

11. Elektronisches Produkt nach Anspruch 10, wobei die genannten Steuermittel ferner einen programmierbaren Dämpfer umfassen.

12. Elektronisches Produkt, das gemäß einem der Verfahren nach den Ansprüchen 1 bis 8 hergestellt wird.

## Revendications

1. Procédé de fabrication d'un produit électronique à partir d'une pluralité de modules électroniques réutilisables (14, 16), opérationnels pour émettre et recevoir des messages sans fil (36) selon un protocole prédéfini, chaque module comprenant des données de description (40) qui décrivent ses possibilités, et où au moins un module est un module principal (16) opérationnel pour établir et coordonner un intranet de produit, le procédé comprenant:
la fourniture d'un plan d'ensemble d'intranet de produit (50) décrivant des modules nécessaires pour le produit,
la sélection de modules pour le produit, y compris un module principal, sur base de données de description respectives de modules et du plan d'ensemble de produit, et
l'établissement d'un intranet de produit (100) comprenant lesdits modules sélectionnés, et ledit produit opérant au moins en partie par cet intranet.

2. Procédé selon la revendication 1, dans lequel ledit plan d'ensemble de produit (50) comprend en outre du code de programme de produit (52) pour ledit module principal, et dans lequel ledit plan d'ensemble est téléchargé vers le module principal avant d'établir ledit intranet de produit.

3. Procédé selon la revendication 1 ou 2, dans lequel les modules comprennent des identificateurs uniques et dans lequel l'établissement dudit intranet de produit comprend l'échange sans fil, par le module principal, d'un identificateur de réseau avec les identificateurs des autres modules sélectionnés afin d'enregistrer lesdits modules.

4. Procédé selon les revendications 1,2 ou la revendication 3, dans lequel les modules sélectionnés sont configurés à l'intérieur d'une zone blindée (82) avant d'établir ledit intranet, afin de garantir que seuls les modules sélectionnés sont inclus dans ledit intranet (100).

5. Procédé selon la revendication 4, dans lequel les modules sont configurés essentiellement à l'intérieur d'un boîtier de produit (10, 12) selon ladite sélection.

6. Procédé selon la revendication 5, dans lequel la puissance d'émission des modules est diminuée pour réduire la portée (60) de l'intranet de produit.

7. Procédé selon la revendication 6, dans lequel la portée de l'intranet est comprise entre un centimètre et un mètre.

8. Procédé selon la revendication 5, dans lequel ledit boîtier de produit (10,12) comprend un blindage qui réduit la portée de l'intranet à essentiellement l'intérieur dudit boîtier.

9. Produit électronique comprenant:
un boîtier (10) possédant une pluralité de modules électroniques (14, 16), chacun possédant un moyen d'émission-réception (24) pour émettre et recevoir des messages (36), et où au moins un des modules est un module principal (16) possédant:
un moyen (16b) pour mémoriser un plan d'ensemble d'intranet de produit; et
des moyens (22,28) pour établir un intranet de produit selon le plan d'ensemble.

10. Produit électronique selon la revendication 9, comprenant en outre un moyen de commande (22) pour commander la sortie de puissance par ledit moyen d'émission-réception.

11. Produit électronique selon la revendication 10, dans lequel ledit moyen de commande comprend en outre un atténuateur programmable.

12. Produit électronique fabriqué selon l'un quelconque des procédés selon les revendications 1 à 8.
